# EUROPEAN PATENT SPECIFICATION

(11) **EP 2 517 268 B1**
(45) Date of publication and mention of the grant of the patent: **04.07.2018**
(21) Application number: 10840056.5
(22) Date of filing: 21.12.2010
(51) Int. Cl.: H01L 31/12, B01J 19/12, C03C 25/10

(54) **UV LED BASED LAMP FOR COMPACT UV CURING LAMP ASSEMBLIES**
LEUCHTE AUF UV-LED-BASIS FÜR ANORDNUNGEN AUS KOMPAKTEN UV-HÄRTENDEN LEUCHTEN
LAMPE À DEL À UV POUR DES ENSEMBLES COMPACTS DE LAMPES DE TRAITEMENT AUX UV

(30) Priority: 23.12.2009 US 289518 P
(43) Date of publication of application: 31.10.2012
(73) Proprietor: Heraeus Noblelight Fusion UV Inc., Gaithersburg, MD 20878 (US)
(72) Inventor: LEONHARDT, Darrin, Gaithersburg MD 20878 (US); WOOD, Charles, H., Rockville MD 20853 (US); SWAIN, Pradyumna, K., Gaithersburg MD 20878 (US)
(74) Representative: Beresford, Keith Denis Lewis
(86) International application number: PCT/US2010/061480
(87) International publication number: WO 2011/079108

(56) References cited:
- US-A- 4 010 374
- US-A1- 2003 068 903
- US-A1- 2003 235 800
- US-A1- 2005 222 295
- US-A1- 2005 222 295
- US-A1- 2007 201 225
- US-B1- 6 386 865

## Description

### FIELD OF THE INVENTION

The invention relates generally to ultraviolet (UV) curing lamp assemblies, and more particularly, to a light-emitting diode (LED)-based lamp for UV curing lamp assemblies.

### BACKGROUND OF THE INVENTION

Radiant energy is used in a variety of manufacturing processes to treat surfaces, films, and coatings applied to a wide range of materials. Specific processes include, but are not limited to, curing (i.e., fixing, polymerization), oxidation, purification, and disinfection. Processes employing radiant energy to polymerize or effect a desired chemical change are rapid and often less expensive compared to a thermal treatment. The radiation can also be localized to control surface processes and allow preferential curing only where the radiation is applied. Curing can also be localized within the coating or thin film to interfacial regions or in the bulk of the coating or thin film. Control of the curing process is achieved through selection of the radiation source type, physical properties (for example, spectral characteristics), spatial and temporal variation of the radiation, and curing chemistry (for example, coating composition).

A variety of radiation sources are used for curing, fixing, polymerization, oxidation, purification, or disinfections applications. Examples of such sources include, but are not limited to, photon, electron, or ion beam sources. Typical photon sources include, but are not limited to, arc lamps, incandescent lamps, electrodeless lamps and a variety of electronic and solid-state sources (i.e., lasers) Conventional arc type UV lamp systems and microwave-driven UV lamp systems use tubular bulb envelopes made of fused quartz glass or fused silica.

United States Patent Application Publication No. US 2005/0222295 A1, to Siegel, for example, discloses an assembly for curing a work product, comprising: a workpiece tube configured to receive the work product; and an array of light emitting diodes 'LEDs' arranged around the workpiece tube. Reflectors are arranged on the opposite side of the workpiece tube to the LED's so that light emitted from the array of LEDs can be focused on the workpiece tube to cure the work product.

United States Patent No. 4,010,374 to Ramler, discloses a heat treatment device of the light irradiation type employing heating lamps at different levels. An assembly of ultra-violet lamp primary sources are arranged to expose the central region of the surface of a work product to more ultraviolet light than at the edges. To compensate for this non-uniform exposure, ultra-violet lamp secondary sources are provided which expose the edges to more ultraviolet light than the central region. The central region and the edges are therefore exposed to approximately equal total amounts of ultraviolet energy per unit area.

United States Patent Application Publication No. US 2003/0068903 A1 to Suzuki et al., is another example of a heat treatment device of the light irradiation type employing heating lamps at different levels, specifically an array of heating lamps at a lower level for heating a wafer with peripheral heating lamps at a higher level for heating a guard ring at the periphery of the wafer.

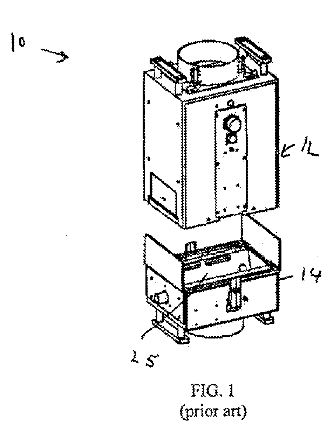

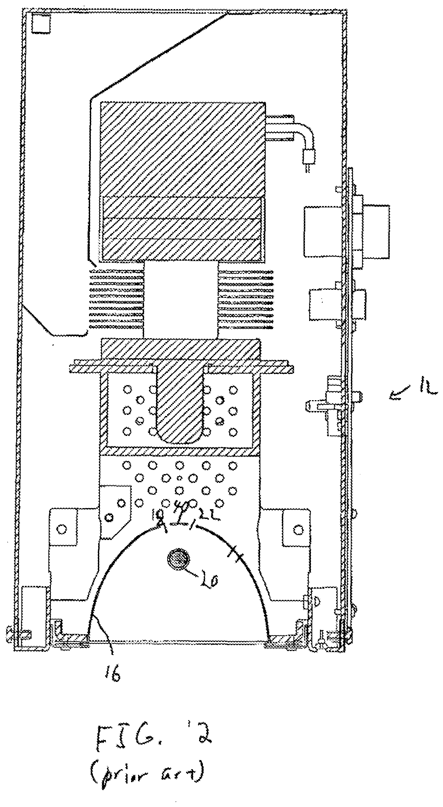

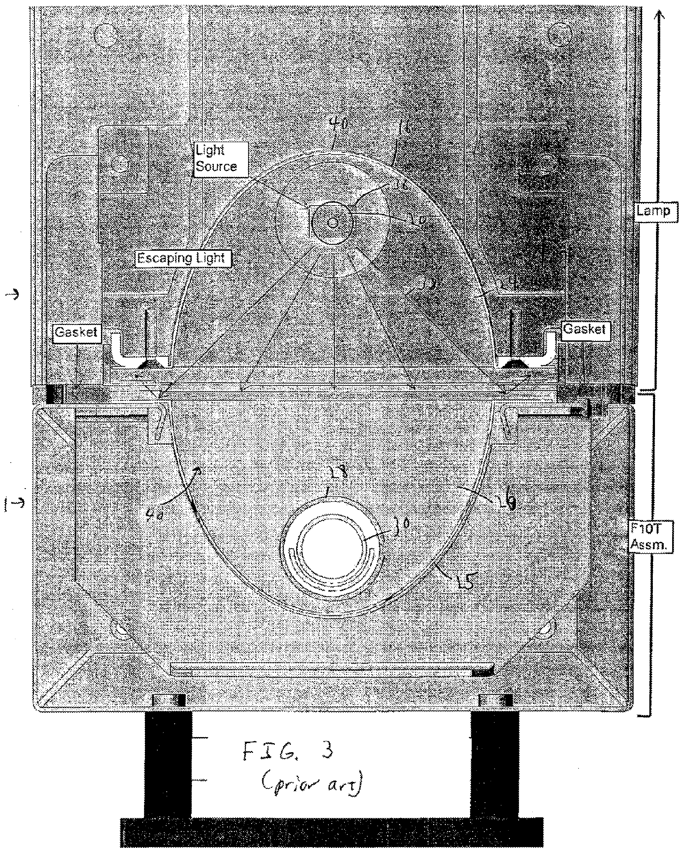

FIG. 1 is a perspective view of a microwave-powered UV curing lamp assembly showing an irradiator and a light shield assembly in the prior art. FIG. 2 is a partial cross-sectional view of the lamp assembly of FIG. 1 showing a half-elliptical primary reflector and a light source of circular cross-section, FIG. 3 is a partial cross-sectional internal view of the light shield assembly of FIG. 1 showing a half-elliptical primary reflector and a light source of circular cross-section mated to a secondary reflector and end reflectors.

Referring now to FIGS. 1-3, the apparatus 10 includes an irradiator 12 and a light shield assembly 14. The irradiator 12 includes a primary reflector 16 having a generally smooth half-elliptical shape with openings 18 for receiving microwave radiation to excite a light source 20 (to be discussed herein below), and a plurality of openings 22 for receiving air flow to cool the light source 20. The light source 20 includes a lamp (e.g., a modular lamp, such as a microwave-powered lamp having a microwave-powered bulb (e.g., tubular bulb with a generally circular cross-section) with no electrodes or glass-to-metal seals). The light source 20 is placed at the internal focus of the half-ellipse formed by the primary reflector 16. The light source 20 and the primary reflector 16 extend linearly along an axis in a direction moving out of the page (not shown). A pair of end reflectors 24 (one shown) terminate opposing sides of the primary reflector 16 to form a substantially half-elliptical reflective cylinder. The light shield assembly 14 of FIG 1-3 includes a secondary reflector 25 having a substantially smooth elliptical shape A second pair of end reflectors 26 (one shown) terminates opposing sides of the secondary reflector 25 to form a substantially half-elliptical reflective cylinder.

A work piece tube 30 of circular cross-section is received in circular openings 28 in the end reflectors 26. The center of the openings 28 and the axis of the work piece tube 30 are typically located at the external focus of the half-ellipse formed by the primary reflector 16 (i.e., the foci of the half-ellipse formed by the secondary reflector 25). The work piece tube 28 and the secondary reflector 25 extend linearly along an axis in a direction moving out of the page (not shown)

In operation, gas in the light source 20 is excited to a plasma state by a source of radio frequency (RF) radiation, such as a magnetron (not shown) located in the irradiator 12. The atoms of the excited gas in the light source 20 return to a lower energy state. thereby emitting ultraviolet light (UV). Ultraviolet light rays 38 radiate from the light source 20 in all directions, striking the inner surfaces of the primary reflector 16, the secondary reflector 25, and the end reflectors 24, 26. Most of the ultraviolet light rays 38 are reflected toward the central axis of the work piece tube 30 The light source 20 and reflector design are optimized to produce the maximum peak light intensity (lamp irradiance) at the surface of a work product (also propagating linearly out of the page) placed inside the work piece tube 30.

Microwave-powered, UV-emitting electrodeless lamps used for the light source have several disadvantages. Microwave-powered, UV-emitting electrodeless lamps are bulky, noisy, and require a large manufacturing and distribution infrastructure due to many consumable parts, since the service lifetime of an electrodeless lamp is relatively short. With present day optics. the focused beam width of an electrodeless lamp is at best about 1 centimeter (comparable to the bulb size), which results in a large amount of wasted light energy that does not strike the work product. In addition, a large amount of energy is also wasted as heat in plasma-based lamp systems (electroded or electrodeless lamps). Since lamps often contain a small amount of mercury, they pose an environmental disposal hazard. In current operation, hazardous operating conditions for personnel when assembling and handling such lamps were alleviated with personal protective equipment and lengthy operating procedures.

Accordingly, what would be desirable, but has not yet been provided, is an environmentally friendly, efficient solid state light source that provides high peak UV curing irradiance.

### SUMMARY OF THE INVENTION

The above-described problems are addressed and a technical solution is achieved in the art by providing an ultraviolet (UV) LED-based lamp for UV curing lamp assemblies.

The present invention is defined in the appended independent claim 1 and to the dependent claims to which reference should be made.

In the embodiments described herein, an array of UV emitting LEDs are packaged together and arranged along the length of at least one optical component configured to focus UV radiation (e.g., refractive optics, reflective optics, adaptive optics, or metamaterials) to form a UV LED-based optical component assembly. The UV LED-based optical component assembly may be made to be modular. The standard length package may be laid end-to-end to increase total irradiance of the UV LED-based optical component assembly.

A UV LED lamp assembly may comprise a plurality of UV LED-based optical component assemblies arranged around a workpiece tube, the workpiece being removably insertable from the workpiece tube. The workpiece tube may be filled with an inert gas and may be made of quartz or UV transparent material. One or more curved back reflectors may be placed on the other side of the workpiece tube, opposite the LED assembly. The curved back reflectors are configured to collect UV light escaping the workpiece tube and refocus the light to the other side of the workpiece. The curvature of the back reflector determines the working distance between the reflector and the workpiece tube.

The UV LEDs may be provided in a prepackaged or bare die form configured with the LED's on a single surface or arranged on multiple surfaces at various levels of a multi-level tiered platform. Preferably, the sidewalls between a lower platform and at least one upper platform are angled or curved inward from the at least one upper platform to the lower platform, such that the at least one upper platform at least partially overlies the lower platform. In this way, the dies are arranged closer to each other than the case of when upper platforms are substantially perpendicular to lower platforms. As a result of the LED dies being closer to each other, the combined irradiance pattern from the plurality of LED dies has been shown to have about a 1.5 power increase per unit area over the conventional linear arrangement.

In operation, the UV LED dies emit UV radiation of a particular wavelength, which is focused onto a stationary or moving workpiece, e.g., an optical fiber, at a predetermined speed. An optical component (eg., a cylindrical lens) focuses light into a desired irradiance pattern, which substantially matches the geometry of the workpiece.

### BRIEF DESCRIPTION OF THE DRAWINGS

The present invention may be more readily understood from the detailed description of an exemplary embodiment presented below considered in conjunction with the attached drawings and in which like reference numerals refer to similar elements and in which:
FIG. 1 is a perspective view of a UV curing lamp assembly showing an irradiator and a light shield assembly in the prior art;
FIG. 2 is a partial cross-sectional view of the lamp assembly of FIG. 1 showing a half-elliptical primary reflector and a light source of circular cross-section;
FIG. 3 is a partial cross-sectional internal view of the lamp assembly interconnected with the light shield assembly of FIG. 1, showing a half-elliptical primary reflector and a light source of circular cross-section mated to a secondary reflector and end reflectors;
FIG. 4 shows a side view of a geometric arrangement of a UV LED array assembly for curing work products, according to an embodiment of the present invention;
FIG. 5A shows a top view of a UV LED lamp assembly with a single UV LED array package and a single back reflector, according to an embodiment of the present invention;
FIG. 5B shows a top view of a UV LED lamp assembly with a plurality of UV LED array packages, according to an embodiment of the present invention;
FIG. 6A shows a linear packaging arrangement of UV LED dies **for comparison with** **FIG. 6B****; and**
FIG. 6B shows a tiered packaging arrangement on a platform of UV LED dies, according to an embodiment of the present invention.

It is to be understood that the attached drawings are for purposes of illustrating the concepts of the invention and may not be to scale.

### DETAILED DESCRIPTION OF THE INVENTION

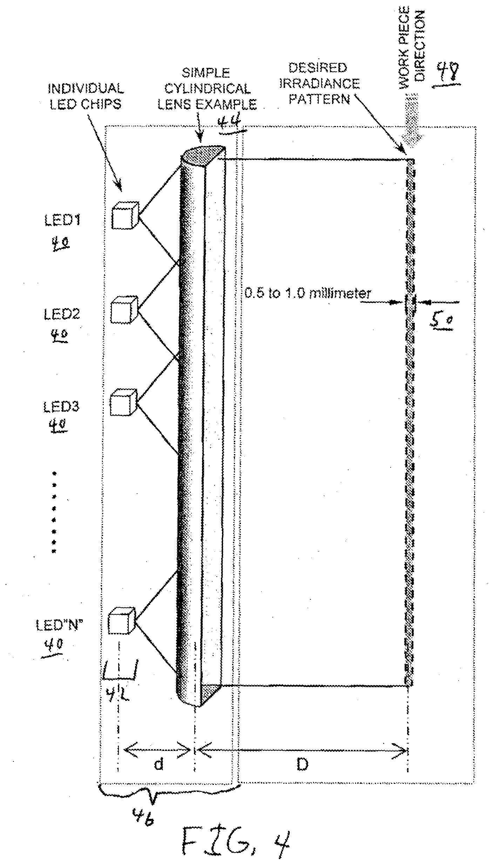

FIG. 4 shows a side view of a geometric arrangement of a UV LED array assembly for curing work products, e.g., optical fibers, according to an embodiment of the present invention. A plurality of UV emitting LED dies 40 are packaged together in a linear array 42, LED1-LED "N". The UV LED dies 40 may emit a single or plurality wavelengths of light below 450 nm.

The UV LED dies 40 may be packaged with **a lens 44.**

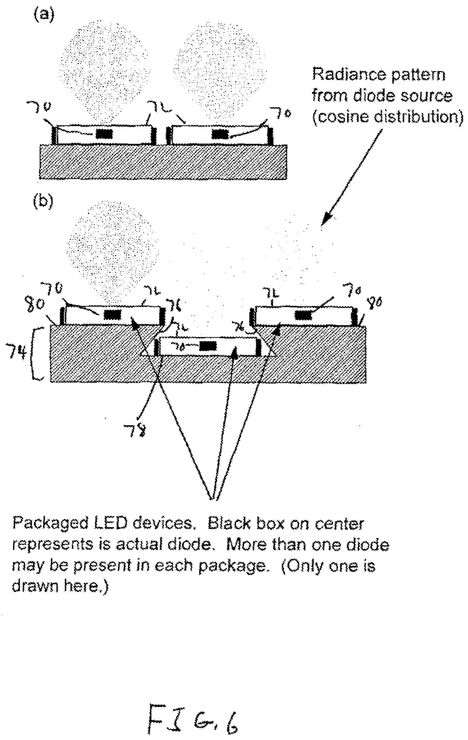

In a preferred embodiment, the **lens** 44 is a cylindrical lens 44 that may be removably attached to the UV LED array 42 or affixed to the UV LED dies 40 to form a UV LED-based optical component assembly 46. The UV LED-based optical component assembly 46 may be made to be modular, i.e., having a specific length and a specific number of UV LED dies 40 per unit length. The standard length package may be laid end-to-end to increase total irradiance of the UV LED-based optical component assembly 46. Irradiance uniformity along the length of the UV LED-baaed optical component assembly 46 may be dictated by the separation between the individual UV LED dies 40 to be discussed hereinbelow with regard to FIG. 6.

In operation, the UV LED dies 40 emit UV radiation of a particular wavelength, which is focused onto a moving workpiece 48, e.g.. an optical fiber, at a predetermined speed. The cylindrical lens 44 focuses light into a desired irradiance pattern, which substantially matches the cross section (e.g., width) of the workpiece 48. In a preferred embodiment, the width 50 of the focused beam at the location of the workpiece 48 is in the range of about 0.5 to 1.0 millimeters.

A typical energy density delivered to the irradiated workpiece 48 moving at about 40 meters/second is about 0.4 Joules/cm². For an irradiance pattern with of about 0.5 mm, the relation 80 = P_{LED}(W) X N_{LED} holds, where P_{LED}(W) is the "useful" output power of each LED die and N_{LED} is the number of total LED dies. The workpiece distance, D. from the center of the cylindrical lens 44 to the workpiece 48 may vary depending on the focal length of the lens 44, but is preferably between 1 and 10 cm. The distance from the center of the half-cylindrical lens 44 to the workpiece 48 is the distance, D, while the distance from the front surfaces of the UV LED dies 40 to the center of the half-cylindrical lens 44 is the distance, d. In a preferred embodiment, d << D.

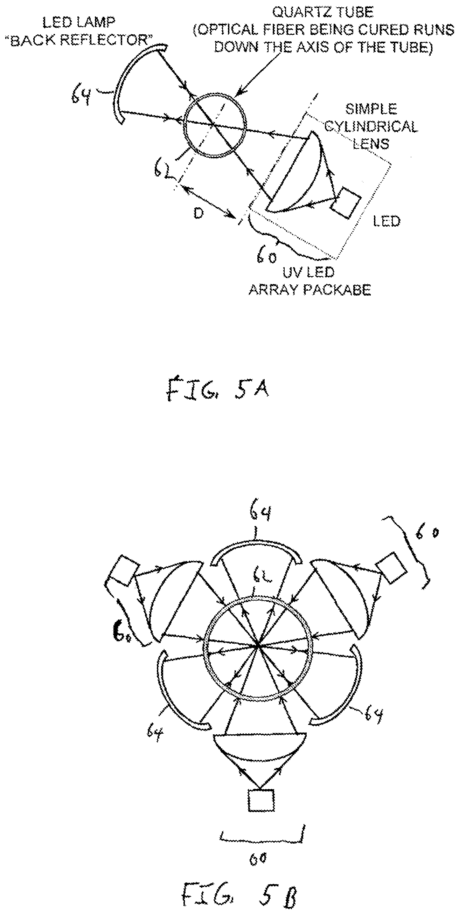

FIG. 5A shows a top view of a UV LED lamp assembly with a single UV LED array package and a single back reflector, while FIG. 5B shows a UV LED lamp assembly with a plurality of UV LED array packages (3 shown), according to an embodiment of the present invention. In principle, one or more LED array packages 60 may be arranged around a workpiece tube 62, the workpiece being removably insertable from the workpiece tube 62 (the workpiece moves into the page down the axis of the workpiece tube 62). The workpiece tube may be filled with an inert gas (i.e., substantially oxygen free). In a preferred embodiment, the workpiece tube 62 may be made of quartz. A person skilled in the art would appreciate that the workpiece tube 62 may be replaced with a less expensive glass tube that provides sufficient optical transparency. One or more curved back reflectors 64 may be placed opposite the LED array packages 60. In this example, the focal length of the curved back reflector 64 is the same as the focal length of the cylindrical lens 44, resulting in the workpiece tube 62 being placed directly between reflector 64 and the lens 44. The curved back reflectors 64 are configured to collect UV light escaping the workpiece tube 62 and refocus the light to the other side of the workpiece. The LED lamp optics (i.e., the LED array packages 60 and/or the curved back reflectors 64 may have optics that compensate for light refraction due to the workpiece tube 62.

The workpiece tube 62 needs to be periodically removed and cleaned, and therefore ought not to be incorporated in a fixed manner into the LED lamp assembly.

FIG. 6A shows a typical linear packaging arrangement of packaged UV LED dies. FIG. 6B shows a tiered packaging arrangement of the UV LED dies, according to **an embodiment** of the present invention. The LED dies 70 may be obtained commercially in a substantially transparent package 72 (e.g., commercially available devices such as the Nichia NC4U13xE) More than one diode may be included in a package 72 Alternatively, bare dies may be purchased and arranged linearly (FIG. 6A) or in a tiered fashion on a multi-level platform 74 (FIG. 6B).

Referring now to FIG 6B, the irradiance pattern emitted by an individual LED die 70 within or not including a rectangular package 72 may be Lambertian (i e., a cosine distribution). When the dies/diode packages 72 are arranged on multiple levels, the sidewalls 76 between a lower platform 78 and at least one upper platform 80 are angled or curved inward from the at least one upper platform 80 to the lower platform 78, such that the at least one upper platform 80 at least partially overlies the lower platform 78. (The exact shape of sidewalls are also dependent on the individual diodes output irradiance pattern.) In this way, the dies are arranged closer to each other than the case of when upper platforms are substantially perpendicular to lower platforms. As a result of the LED dies 70 being closer to each other, the combined irradiance pattern from the plurality of LED dies 70 has been shown to have about a 1.5 power increase per unit area over the conventional linear arrangement of FIG. 6A Moreover, the spatial uniformity of irradiance for the tiered configuration is greater than that of a linear, single level configuration.

The tiered multi-level platform 74 may be provided with appropriate electrical connections and thermal management for diode operation, as in the standard planar platform shown in FIG 6A.

The present invention has several advantages over traditional traditional microwave powered lamps. LED-based UV curing lamps offer fewer environmental contaminants and lower operating costs over their life time. An LED-based lamp uses only the solid state device (diode) that have a service life times of many of thousands of hours. An LED-based lamp has essentially no consumable parts compared to the traditional microwave powered lamp Using traditional optics, all of the emitted light from the LEDs may be focused on to a small area of a fiber (less than 500 microns), whereas present day curing platforms can only focus the output light to approximately 1 centimeter (10,000 microns). Therefore, a UV LED-based lamp can offer a much smaller footprint than microwave or arc lamps and can be better configured to fit around the cylindrical geometry of an optical fiber to be cured In addition, LED lamps can be modularized in to smaller sections to permit custom designs Both of these last two points can greatly reduce scattered light and therefore worker safety in an industrial environment.

Because of their presently limited monochromatic spectrum and low powers, traditional UV LED-based lamps typically suffer from insufficient curing results, due to oxygen inhibition and the desire for maximum process speeds However, in the present invention, optical fiber coatings are (i) cured in a moderately oxygen-free environment, (ii) have small substrates, and (iii), rely primarily on the UVA (320-390nm) band for curing Thus, the entire optical output of UV LEDs of the present invention may be focused on the small fiber area to produce the large energy densities required for the high processing speeds used for curing optical fibers. Coating chemistry may be further optimized for the UVA band (where higher-power LEDs are available).

In applications where inert (low oxygen content) environments are used, short working distance may be employed. A UV LED-based lamp as outlined herein may be used to cure coatings on the interior (or exterior) of pipes where space is highly limited and the environment may be purged of oxygen to improve cure performance. Due to the availability of present day diodes, a high sensitivity of the chemistry to the UVA band is preferred, however, as the technology improves (LED wavelengths become shorter and output powers increase) UV LED-based lamps may be applied to a wider range of chemistries and therefore more applications. For instance, ink jet priming requires a close working distance, but the chemistry requires UVA and UVC (240-250nm) bands and it is unattractive to purge the large substrates to reduce the oxygen inhibition problem. However, an LED-based lamp with both UVA and UVC wavelengths may greatly reduce these barriers, after significant advancements in UV LED materials and devices have been made.

It is to be understood that the exemplary embodiments are merely illustrative of the invention and that many variations of the above-described embodiments may be devised by one skilled in the art without departing from the scope of the invention It is therefore intended that all such variations be included within the scope of the following claims.

## Claims

1. An assembly for curing a work product, comprising:
a workpiece tube (62) configured to receive the work product;
a lens (44) arranged substantially parallel to the workpiece tube (62); and
an array (42) of light emitting diodes 'LEDs' (40; 70) arranged on a tiered platform (74) having at least two levels, wherein a first LED (40; 70) is located on a first level (78) of the tiered platform (74) and a second LED (40; 70) is located on a second level (80) of the tiered platform (74), wherein the second level (80) of the tiered platform (74) is closer to the lens (44) than the first level (78) of the tiered platform (74);
wherein light emitted from the array (42) of LEDs (40; 70) is focused by the lens (44) on the workpiece tube (62) to cure the work product.

2. The assembly of claim 1, wherein the second level (80) of the tiered platform (74) at least partially overlaps the first level (78) of the tiered platform (74) such that the first and second LEDs (40; 70) are arranged closer together than if the first level (78) of the tiered platform (74) and the second level (80) of the tiered platform (74) did not overlap.

3. The assembly of claim 2, wherein a surface of the tiered platform (74) connecting the first level (78) of the tiered platform (74) and the second level (80) of the tiered platform (74) is flat.

4. The assembly of claim 2, wherein a surface (76) of the tiered platform (74) connecting the first level (78) of the tiered platform (74) and the second level (80) of the tiered platform (74) is curved.

5. The assembly of claim 1, further including a curved reflector (64) located substantially parallel to the workpiece tube (62) and distal to the tiered platform (74), wherein the curved reflector (64) is configured to refocus light emitted from the array (42) of LEDs (40; 70) that escapes the workpiece tube (62) substantially back onto the workpiece tube (62).

6. The assembly of claim 5, wherein a curvature of the elongated curved reflector (64) determines a working distance between the elongated curved reflector (64) and the workpiece tube (62).

7. The assembly of claim 1, wherein the array (42) of LEDs (40; 70) emits ultraviolet 'UV' light of at least one wavelength.

8. The assembly of claim 1, wherein each one of the array (42) of LEDs (40; 70) is a prepackaged or bare die (70).

9. The assembly of claim 1, wherein a distance (d) between the array (42) of LEDs (40; 70) and the lens (44) is substantially less than a distance (D) between the lens (44) and the workpiece tube (62).

10. The assembly of claim 1, wherein the lens (44) forms a curved, half-cylinder with a substantially flat surface proximal to the workpiece tube (62).

11. The assembly of claim 1, wherein the workpiece tube (62) is substantially transparent to UV light.

12. The assembly of claim 1, wherein the workpiece tube (62) is substantially filled with an inert gas.

## Patentansprüche

1. Anordnung zum Härten eines Arbeitsprodukts, umfassend:
ein Werkstückrohr (62), das konfiguriert ist, um das Arbeitsprodukt aufzunehmen;
eine Linse (44), die im Wesentlichen parallel zum Werkstückrohr (62) angeordnet ist; und
ein Feld (42) von Leuchtdioden 'LEDs' (40; 70), die auf einer gestuften Plattform (74) mit wenigstens zwei Ebenen angeordnet sind, wobei eine erste LED (40; 70) auf einer ersten Ebene (78) der gestuften Plattform (74) angeordnet ist und eine zweite LED (40; 70) auf einer zweiten Ebene (80) der gestuften Plattform (74) angeordnet ist, wobei die zweite Ebene (80) der gestuften Plattform (74) näher an der Linse (44) ist als die erste Ebene (78) der gestuften Plattform (74);
wobei vom Feld (42) von LEDs (40; 70) emittiertes Licht durch die Linse (44) auf die Werkstückröhre (62) fokussiert wird, um das Arbeitsprodukt zu härten.

2. Anordnung nach Anspruch 1, wobei die zweite Ebene (80) der gestuften Plattform (74) die erste Ebene (78) der gestuften Plattform (74) wenigstens teilweise derart überlappt, dass die erste und die zweite LED (40; 70) näher beieinander angeordnet sind, als wenn die erste Ebene (78) der gestuften Plattform (74) und die zweite Ebene (80) der gestuften Plattform (74) einander nicht überlappen würden.

3. Anordnung nach Anspruch 2, wobei eine Oberfläche der gestuften Plattform (74), welche die erste Ebene (78) der gestuften Plattform (74) und die zweite Ebene (80) der gestuften Plattform (74) verbindet, flach ist.

4. Anordnung nach Anspruch 2, wobei eine Oberfläche (76) der gestuften Plattform (74), welche die erste Ebene (78) der gestuften Plattform (74) und die zweite Ebene (80) der gestuften Plattform (74) verbindet, gekrümmt ist.

5. Anordnung nach Anspruch 1, ferner umfassend einen gekrümmten Reflektor (64), der im Wesentlichen parallel zum Werkstückrohr (62) und entfernt zur gestuften Plattform (74) angeordnet ist, wobei der gekrümmte Reflektor (64) so konfiguriert ist, um vom Feld (42) der LEDs (40; 70) emittiertes Licht, das dem Werkstückrohr (62) entkommt, im Wesentlichen zurück auf das Werkstückrohr (62) zu fokussieren.

6. Anordnung nach Anspruch 5,
wobei eine Krümmung des länglichen gekrümmten Reflektors (64) einen Arbeitsabstand zwischen dem länglichen gekrümmten Reflektor (64) und dem Werkstückrohr (62) bestimmt.

7. Anordnung nach Anspruch 1, wobei das Feld (42) der LEDs (40; 70) ultraviolettes 'UV'-Licht von wenigstens einer Wellenlänge emittiert.

8. Anordnung nach Anspruch 1, wobei jedes der Felder (42) der LEDs (40; 70) ein bereits verpackter oder ein nackter Chip (70) ist.

9. Anordnung nach Anspruch 1, wobei ein Abstand (d) zwischen dem Feld (42) der LEDs (40; 70) und der Linse (44) wesentlich kleiner ist als ein Abstand (D) zwischen der Linse (44) und dem Werkstückrohr (62).

10. Anordnung nach Anspruch 1, wobei die Linse (44) ein gekrümmter Halbzylinder mit einer im Wesentlichen ebenen Oberfläche nahe zum Werkstückrohr (62) ist.

11. Anordnung nach Anspruch 1, wobei das Werkstückrohr (62) im Wesentlichen transparent für UV-Licht ist.

12. Anordnung nach Anspruch 1, wobei das Werkstückrohr (62) im Wesentlichen mit einem Inertgas gefüllt ist.

## Revendications

1. Ensemble pour le durcissement d'un produit à traiter, comprenant :
un tube pour pièce à traiter (62) conçu pour recevoir le produit à traiter ;
une lentille (44) disposée globalement parallèlement au tube pour pièce à traiter (62) ; et
une série (42) de diodes électroluminescentes 'DEL' (40 ; 70) disposées sur une plate-forme multiniveau (74) qui présente au moins deux niveaux, une première LED (40 ; 70) se trouvant sur un premier niveau (78) de la plate-forme multiniveau (74), et une deuxième LED (40 ; 70) se trouvant sur un deuxième niveau (80) de la plate-forme multiniveau (74), le deuxième niveau (80) de la plate-forme multiniveau (74) se trouvant plus près de la lentille (44) que le premier niveau (78) de la plate-forme multiniveau (74)
la lumière émise à partir de la série (42) de LED (40 ; 70) étant focalisée par la lentille (44) sur le tube pour pièce à traiter (62), en vue du durcissement du produit à traiter.

2. Ensemble de la revendication 1, dans lequel le deuxième niveau (80) de la plate-forme multiniveau (74) recouvre au moins en partie le premier niveau (78) de la plate-forme multiniveau (74) de telle sorte que les premières et deuxièmes LED (40 ; 70) sont plus rapprochées que si le premier niveau (78) de la plate-forme multiniveau (74) et le deuxième niveau (80) de la plate-forme multiniveau (74) ne se recouvraient pas.

3. Ensemble de la revendication 2, dans lequel une surface de la plate-forme multiniveau (74) qui relie le premier niveau (78) de la plate-forme multiniveau (74) et le deuxième niveau (80) est plate.

4. Ensemble de la revendication 2, dans lequel une surface de la plate-forme multiniveau (74) qui relie le premier niveau (78) de la plate-forme multiniveau (74) et le deuxième niveau (80) est courbe.

5. Ensemble de la revendication 1, comprenant également un réflecteur courbe (64) qui est globalement parallèle au tube pour pièce à traiter (62) et distal par rapport à la plate-forme multiniveau (74), le réflecteur courbe (64) étant conçu pour refocaliser globalement vers le tube pour pièce à traiter (62) la lumière émise à partir de la série (42) de LED (40 ; 70) qui sort du tube pour pièce à traiter (62).

6. Ensemble de la revendication 5, dans lequel une courbure du réflecteur courbe oblong (64) détermine une distance de traitement entre ledit réflecteur courbe oblong (64) et le tube pour pièce à traiter (62).

7. Ensemble de la revendication 1, dans lequel la série (42) de LED (40 ; 70) émet une lumière ultraviolette 'UV' d'au moins une longueur d'onde.

8. Ensemble de la revendication 1, dans lequel chacune des LED (40 ; 70) de la série (42) est une matrice (70) pré-emballée ou nue.

9. Ensemble de la revendication 1, dans lequel une distance (d) entre la série (42) de LED (40 ; 70) et la lentille (44) est globalement inférieure à une distance (D) entre la lentille (44) et le tube pour pièce à traiter (62) .

10. Ensemble de la revendication 1, dans lequel la lentille (44) forme un demi-cylindre courbe avec une surface globalement plate proximale par rapport au tube pour pièce à traiter (62).

11. Ensemble de la revendication 1, dans lequel le tube pour pièce à traiter (62) est globalement transparent à la lumière UV.

12. Ensemble de la revendication 1, dans lequel le tube pour pièce à traiter (62) est globalement rempli avec un gaz inerte.
